# EUROPEAN PATENT APPLICATION

(11) **EP 4 770 349 A1**
(43) Date of publication of application: **01.07.2026**
(21) Application number: 24887528.8
(22) Date of filing: 12.08.2024
(51) Int. Cl.: H10F 99/00

(54) **PHOTOVOLTAIC BACKSHEET AND PHOTOVOLTAIC MODULE**

(30) Priority: 10.11.2023 CN 202323045991 U
(71) Applicant: Longi Green Energy Technology Co., Ltd., Xi'an, Shaanxi 710100 (CN)
(72) Inventor: WU, Qian, Xi'an, Shaanxi 710100 (CN); GAO, Chunxiang, Xi'an, Shaanxi 710100 (CN); YANG, Zhengqiang, Xi'an, Shaanxi 710100 (CN); YU, Yonglin, Xi'an, Shaanxi 710100 (CN); FENG, Chunnuan, Xi'an, Shaanxi 710100 (CN); WANG, Yongfeng, Xi'an, Shaanxi 710100 (CN)
(74) Representative: Grünecker Patent- und Rechtsanwälte PartG mbB
(86) International application number: PCT/CN2024/111573
(87) International publication number: WO 2025/097908

(57) **Abstract**

Disclosed are a photovoltaic backsheet and a photovoltaic module. The photovoltaic backsheet includes a backsheet body. The backsheet body is provided with at least one terminal lead-out hole, and the terminal lead-out hole is adapted for passage of lead-out terminals of the photovoltaic module. The terminal lead-out hole runs through two opposite sides of the backsheet body in a first direction, and a projection trajectory of the terminal lead-out hole in the first direction is composed of a plurality of line segments. The plurality of line segments include a first elliptical arc segment and a second elliptical arc segment arranged opposite to each other in a second direction, and a first circular arc segment and a second circular arc segment arranged opposite to each other in a third direction, or, a first straight line segment or a first polyline segment or another line segment and a second straight line segment or a second polyline segment or another line segment arranged opposite to each other in the third direction. The second direction intersects with the third direction. Such a terminal lead-out hole structure not only provides enough space for passage of lead-out terminals, but also improves the proper structural layout of the terminal lead-out hole on the backsheet body. In addition, an effective usable area of the backsheet body occupied by the terminal lead-out hole is reduced, thus improving the usage performance of the photovoltaic backsheet.

## Description

### CROSS-REFERENCE TO RELATED APPLICATIONS

The present application claims priority and benefits to Chinese Patent Application No. 202323045991.9, filed on November 10, 2023, which is incorporated herein by reference in its entirety.

### TECHNICAL FIELD

The present application belongs to the field of photovoltaic technology, and in particular, to a photovoltaic backsheet and a photovoltaic module.

### BACKGROUND

Solar photovoltaic modules, also known as solar panels, serve to convert solar energy into electrical energy. This electrical energy is either delivered to be stored in storage batteries or to drive loads to work. A structure of a solar photovoltaic module mainly includes a front glass, solar cell strings, and a backsheet. The solar cell strings absorb solar energy and convert the solar energy into electrical energy. Busbars are arranged on the solar cell strings, and the busbars are used for collecting the electrical energy and leading the electrical energy to a junction box arranged on the backsheet. The junction box is then connected to external circuits or electrical devices to supply power to the external circuits or the electrical devices.

In the related art, the backsheet is provided with through holes, and the busbars on the solar cell strings pass through the through holes to connect to the junction box on the backsheet. In the related art, the through holes in the backsheet are typically designed as circular holes or elliptical holes. However, when the through holes are designed as the circular holes, stress concentration occurs around the circular holes, making the backsheet prone to cracking around the circular holes when subjected to force. On the other hand, although designing the through holes as the elliptical holes can reduce stress concentration of portions around the through holes, forming the elliptical holes requires occupying more effective usable area of the backsheet, thereby increasing drilling machining costs to certain extent.

### SUMMARY

The present application aims to provide a photovoltaic backsheet and a photovoltaic module, to partially or fully solve technical problems in the related art that when through holes are formed in a backsheet, if the through holes are designed as circular holes, the backsheet is prone to cracking around the circular holes when subjected to force; and if the through holes are designed as elliptical holes, forming the elliptical holes requires occupying more effective usable area of the backsheet. To solve the above-mentioned technical problems, the present application is implemented as follows:
According to a first aspect, the present application provides a photovoltaic backsheet, which includes a backsheet body.

The backsheet body is provided with at least one terminal lead-out hole. The terminal lead-out hole is adapted for passage of lead-out terminals of the photovoltaic module. The terminal lead-out hole runs through two opposite sides of the backsheet body in a first direction, and a projection trajectory of the terminal lead-out hole in the first direction is composed of a plurality of line segments.

The plurality of line segments include a first elliptical arc segment and a second elliptical arc segment arranged opposite to each other in a second direction, and
a first circular arc segment and a second circular arc segment arranged opposite to each other in a third direction, where the second direction intersects with the third direction;
or, a first straight line segment or a first polyline segment or another line segment and a second straight line segment or a second polyline segment or another line segment arranged opposite to each other in the third direction, where the another line segment includes a line segment formed by combining a straight line and a curve; and the second direction intersects with the third direction.

In an embodiment, a maximum dimension of the projection trajectory in the third direction is greater than a maximum dimension of the projection trajectory in the second direction; and/or, the first direction is perpendicular to the second direction and the third direction, and the second direction is perpendicular to the third direction.

In an embodiment, the backsheet body includes two opposite short edges and two opposite long edges. The second direction is set parallel to an extending direction of the long edges, and the third direction is set parallel to an extending direction of the short edges; or, the second direction is set parallel to the extending direction of the short edges, and the third direction is set parallel to the extending direction of the long edges.

In an embodiment, a maximum dimension of the projection trajectory in the third direction is A, satisfying: A < 20 mm; and/or, a maximum dimension of the projection trajectory in the second direction is B, satisfying: 6 mm ≤ B ≤ 18 mm.

In an embodiment, the first elliptical arc segment and the second elliptical arc segment are symmetrically distributed about an axis in the second direction, or, the first elliptical arc segment and the second elliptical arc segment are asymmetrically distributed in the second direction;
and/or, the first circular arc segment and the second circular arc segment are symmetrically distributed about an axis in the third direction, or, the first circular arc segment and the second circular arc segment are asymmetrically distributed in the third direction.

In an embodiment, the first elliptical arc segment and the second elliptical arc segment are located on a same ellipse; or, the first circular arc segment and the second circular arc segment are located on a same circle; or, a line connecting a center of an ellipse where the first elliptical arc segment is located and a center of an ellipse where the second elliptical arc segment is located is parallel to the second direction; or, a line connecting a center of a circle where the first circular arc segment is located and a center of a circle where the second circular arc segment is located is parallel to the third direction.

In an embodiment, a length of a major axis of an ellipse where the first elliptical arc segment is located is A1, and a length of a minor axis of the ellipse is B1, satisfying: 1.1 ≤ A1/B1 ≤ 1.9; and/or, a length of a major axis of an ellipse where the second elliptical arc segment is located is A2, and a length of a minor axis of the ellipse is B2, satisfying: 1.1 ≤ A2/B2 ≤ 1.9.

In an embodiment, the lengths A1 and A2 of the major axes of the ellipses satisfy: 8 mm ≤ A1 ≤ 20 mm, and 8 mm ≤ A2 ≤ 20 mm; and/or, the lengths B1 and B2 of the minor axes of the ellipses satisfy: 6 mm ≤ B1 ≤ 15 mm, and 6 mm ≤ B2 ≤ 15 mm.

In an embodiment, the lengths A1 and A2 of the major axes of the ellipses are both 18 mm or 16 mm, and the lengths B1 and B2 of the minor axes of the ellipses are both 10 mm or 12 mm.

In an embodiment, a radius of a circle where the first circular arc segment is located is R11, satisfying: 3 mm ≤ R11 ≤ 10 mm; or, a radius of a circle where the second circular arc segment is located is R12, satisfying: 3 mm ≤ R12 ≤ 10 mm.

In an embodiment, the first elliptical arc segment and the second elliptical arc segment are located on a same ellipse, the first circular arc segment and the second circular arc segment are located on a same circle, and a distance between a center of the ellipse and a center of the circle is L, satisfying: 0 mm ≤ L ≤ 3 mm.

In an embodiment, the center of the ellipse coincides with the center of the circle; and/or, the radius R11 of the circle where the first circular arc segment is located is 3 mm, 4 mm, 5 mm, 6 mm, 7 mm, 8 mm, 9 mm; and/or, the radius R12 of the circle where the second circular arc segment is located is 3 mm, 4 mm, 5 mm, 6 mm, 7 mm, 8 mm, 9 mm.

In an embodiment, when the first circular arc segment and the second circular arc segment are arranged opposite to each other in the third direction, the plurality of line segments further include at least one arc-shaped transition segment. The arc-shaped transition segment is arranged between the adjacent elliptical arc segment and circular arc segment. One end of the arc-shaped transition segment is connected to one of the first elliptical arc segment and the second elliptical arc segment, and the other end of the arc-shaped transition segment is connected to one of the first circular arc segment and the second circular arc segment.

In an embodiment, the arc-shaped transition segment is of a circular arc structure, and a radius of the circular arc structure is R2, satisfying: 0 mm < R2 ≤ 5 mm.

In an embodiment, the radius R2 of the circular arc structure of the arc-shaped transition segment is 1 mm, 2 mm, 3 mm, 4 mm, 5 mm.

In an embodiment, at least one side surface of the backsheet body is provided with a glaze layer, and a first gap exists between the glaze layer and the terminal lead-out hole.

In an embodiment, a dimension of the first gap is M1, satisfying: 3.5 mm ≤ M1 ≤ 9.5 mm.

In an embodiment, the terminal lead-out hole is offset from a center of the backsheet body; or, the backsheet is a glass backsheet; or, the first circular arc segment and the second circular arc segment are located on a same circle, and a line connecting a center of an ellipse where the first elliptical arc segment is located, a center of the circle, and a center of an ellipse where the second elliptical arc segment is located is parallel to the second direction; or, the first elliptical arc segment and the second elliptical arc segment are located on a same ellipse, and a line connecting a center of a circle where the first circular arc segment is located, a center of the ellipse, and a center of a circle where the second circular arc segment is located is parallel to the third direction; or, the first circular arc segment or the first straight line segment or the first polyline segment or the another line segment, the first elliptical arc segment, the second circular arc segment or the second straight line segment or the second polyline segment or the another line segment, and the second elliptical arc segment are connected.

In an embodiment, the photovoltaic backsheet is used in a photovoltaic module, and the photovoltaic module is capable of bearing mechanical loads greater than or equal to 2400 Pa.

In an embodiment, the mechanical loads are static mechanical loads.

According to a second aspect, the present application further provides a photovoltaic module, which includes: solar cell strings, lead-out terminals, and the photovoltaic backsheet according to any one of the above-mentioned embodiments. One end of the lead-out terminal is connected to the solar cell strings, and the other end of the lead-out terminal passes through the terminal lead-out hole.

In an embodiment, two lead-out terminals pass through the same terminal lead-out hole. The two lead-out terminals are at least partially parallel to each other, and the two lead-out terminals are arranged to be spaced apart in the third direction.

In an embodiment, in the third direction, a spacing between the two lead-out terminals is M2, satisfying: 3 mm ≤ M2 ≤ 15 mm.

In an embodiment, a sum of the spacing and thicknesses of the two lead-out terminals in the third direction is less than a maximum dimension of the projection trajectory in the third direction.

In an embodiment, a width of the lead-out terminal in the second direction is less than a maximum dimension of the projection trajectory in the second direction.

In the embodiments of the present application, by arranging the at least one terminal lead-out hole in the photovoltaic backsheet, the lead-out terminals in the photovoltaic module pass through the terminal lead-out hole. The lead-out terminals run through the two opposite sides of the backsheet body in the first direction, and the projection trajectory of the terminal lead-out hole in the first direction is composed of the plurality of line segments. The plurality of line segments include the two elliptical arc segments arranged opposite to each other in the second direction Y and the two circular arc segments arranged opposite to each other in the third direction Z. By adopting the terminal lead-out hole structure in the present application, a sufficient space is provided for the passage of the lead-out terminals, and meanwhile a proper structural layout of the terminal lead-out hole in the backsheet body is improved, thereby improving a load-bearing capacity of the photovoltaic module when the photovoltaic backsheet is used in the photovoltaic module. Moreover, by adopting the terminal lead-out hole structure in the present application, the effective usable area of the backsheet body occupied by the terminal lead-out hole is reduced, and the four-point bending strength of the backsheet body is improved, thereby improving usage performance of the photovoltaic backsheet.

Additional aspects and advantages of the present application will be given in the following description, some of which will become apparent from the following description or may be learned from practices of the present application.

### BRIEF DESCRIPTION OF THE DRAWINGS

The foregoing and/or additional aspects and advantages of the present application will become apparent and comprehensible in the description of the embodiments made with reference to the following accompanying drawings.
FIG. 1 is a schematic diagram of a photovoltaic backsheet according to an embodiment of the present application;
FIG. 2 is a schematic structural diagram of a glaze layer and a terminal lead-out hole in a photovoltaic backsheet according to an embodiment of the present application;
FIG. 3 is a schematic cross-sectional view showing a partial structure of the cooperation between some terminal lead-out holes and lead-out terminals according to an embodiment of the present application;
FIG. 4 is a schematic top view showing a cooperation structure between a terminal lead-out hole and lead-out terminals according to an embodiment of the present application;
FIG. 5 is a schematic diagram of a projection trajectory of a first type of terminal lead-out hole according to an embodiment of the present application;
FIG. 6 is a schematic diagram illustrating formation of the projection trajectory of the terminal lead-out hole in FIG. 5 according to an embodiment of the present application;
FIG. 7 is a schematic structural diagram of a projection trajectory of a second type of terminal lead-out hole according to an embodiment of the present application;
FIG. 8 is a schematic structural diagram of a projection trajectory of a third type of terminal lead-out hole according to an embodiment of the present application;
FIG. 9 is a schematic structural diagram of a projection trajectory of a fourth type of terminal lead-out hole according to an embodiment of the present application;
FIG. 10 is a schematic structural diagram of a projection trajectory of a fifth type of terminal lead-out hole according to an embodiment of the present application; and
FIG. 11 is an enlarged view of a circled section C according to an embodiment of the present application.

### Reference numerals:

100: backsheet body; 101: short edge; 102: long edge; 110: terminal lead-out hole; 111: projection trajectory; a1: first elliptical arc segment; a2: second elliptical arc segment; b1: first circular arc segment; b2: second circular arc segment; 112: ellipse; 112a: center of ellipse; 113: circle; 113a: center of circle; 114: arc-shaped transition segment; 200: glaze layer; 300: lead-out terminal; X: first direction; Y: second direction; and Z: third direction.

### DETAILED DESCRIPTION

Embodiments of the present application are described in detail below, and examples of the embodiments are shown in accompanying drawings, where the same or similar numerals denote the same or similar elements or elements having the same or similar functions throughout the description. The embodiments described below with reference to the accompanying drawings are exemplary and used only for explaining the present application, and should not be construed as a limitation on the present application. All other embodiments obtained by those of ordinary skill in the art based on the embodiments of the present application without making creative efforts shall fall within the scope of protection of the present application.

In the specification and claims of the present application, features of the terms "first" and "second" explicitly or implicitly include one or more of the features. In the description of the present application, unless otherwise stated, "a plurality of" means two or more than two. In addition, in the specification and the claims, "and/or" indicates at least one of connected objects, and the character "/" generally indicates an "or" relationship between associated objects before and after it.

In the description of the present application, it should be understood that the orientation or position relationships indicated by the terms "center", "longitudinal", "transverse", "length", "width", "thickness", "upper", "lower", "front", "back", "left", "right", "vertical", "horizontal", "top", "bottom", "inner", "outer", "clockwise", "anticlockwise", "axial direction", "radial direction", "circumferential direction", and the like are based on the orientation or position relationships shown in the accompanying drawings and are intended to facilitate the description of the present application and simplify the description only, rather than indicate or imply that an apparatus or element referred to need to have a particular orientation or be constructed and operated in a particular orientation, and therefore are not to be understood as limitations on the present application.

In the description of the present application, it should be noted that the terms "mounted", "connected", and "linked" should be understood in a broad sense, unless otherwise explicitly specified and limited. For example, a connection may be a fixed connection, a detachable connection, or an integrated connection; a connection may be a mechanical connection or an electrical connection; or a connection may be a direct connection, a sequential connection, an indirect connection through an intermediate medium, or a communication between interiors of two elements. Those of ordinary skill in the art should understand specific meanings of the above-mentioned terms in the present application according to specific situations.

Before providing an explanation of a photovoltaic backsheet and a photovoltaic module provided in the embodiments of the present application, application scenarios of the photovoltaic backsheet and the photovoltaic module provided in the embodiments of the present application are specifically described first.

Typically, the photovoltaic module includes a front sheet, solar cell strings, and a backsheet. The front sheet and the backsheet are arranged on two sides of the solar cell strings to provide protection for the solar cell strings. The solar cell strings receive sunlight and generates electrical energy through a photoelectric conversion effect. Lead-out terminals are arranged on the solar cell strings, while a terminal lead-out hole is formed in the backsheet. A junction box is arranged at a position, corresponding to the terminal lead-out hole, of one side of the backsheet away from the solar cell strings. The lead-out terminals on the solar cell strings pass through the terminal lead-out hole to be connected with the junction box, and then, the photovoltaic module is connected with an external circuit or electrical device through the junction box, thereby exporting the electrical energy generated by the photovoltaic module.

Typically, a laser drilling method is employed to machine and form the terminal lead-out hole in the backsheet. For ease of machining and machining cost reduction, the terminal lead-out hole is typically designed as a circular hole. However, forming the circular hole in the backsheet reduces structural strength of the backsheet. When subjected to external force, the backsheet is prone to cracking around the circular hole in the backsheet. Moreover, a stress distribution of a region around the circular hole is uneven in a width direction and a length direction of the backsheet, thereby affecting overall structural strength of the backsheet.

In the related art, by modifying the terminal lead-out hole from the circular hole into an elliptical hole, with a major axis extending direction of the elliptical hole kept aligned with the width direction of the backsheet, the stress distribution around the terminal lead-out hole is improved. However, although employing the elliptical hole as the terminal lead-out hole alleviates stress concentration of the backsheet around the terminal lead-out hole to certain extent, the following defects are present:
1) Although forming the elliptical hole in the backsheet results in a more balanced stress distribution around the terminal lead-out hole, thereby reducing stress concentration in a portion around the terminal lead-out hole of the backsheet, compared to conventional circular holes, forming the elliptical hole requires occupying more effective usable area of the backsheet and reduces an effective bonding area between the backsheet and components such as the junction box, increasing the risk of the junction box detaching from the backsheet to certain extent.
2) In an assembly process of the photovoltaic module, after the lead-out terminals pass through the terminal lead-out hole, a blank region needs to be filled with an adhesive film. However, using the elliptical hole increases the amount of the adhesive film required for filling, thereby increasing production costs.
3) The terminal lead-out hole is typically machined through the laser drilling method, and employing the elliptical hole adds a machining path required for drilling, thereby increasing machining costs.

Based on the above-mentioned problems, on one hand, the present application provides a photovoltaic backsheet and a photovoltaic module that can effectively reduce the effective usable area of the backsheet occupied by the terminal lead-out hole, thereby enhancing usage performance of the backsheet while reducing the production costs. In combination with the accompanying drawings, the following provides detailed descriptions of the photovoltaic backsheet and the photovoltaic module provided in the embodiments of the present application through specific embodiments and application scenarios thereof.

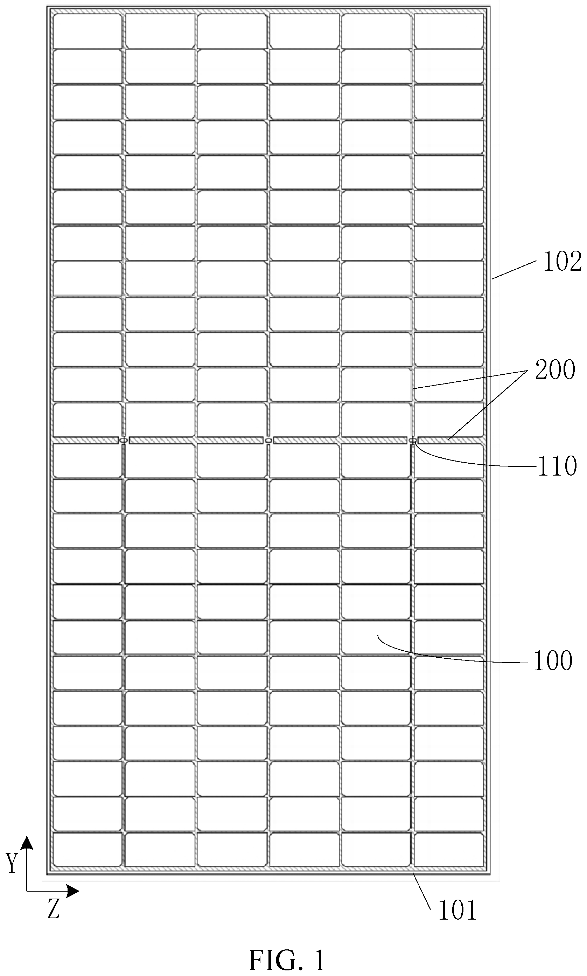

As shown in FIG. 1 to FIG. 9, the photovoltaic backsheet according to some embodiments of the present application includes: a backsheet body 100. The backsheet body 100 is provided with at least one terminal lead-out hole 110. The terminal lead-out hole 110 is adapted for passage of lead-out terminals 300 of the photovoltaic module. The lead-out terminals 300 run through two opposite sides of the backsheet body 100 in a first direction X, and a projection trajectory 111 of the terminal lead-out hole 110 in the first direction X is composed of a plurality of line segments. The plurality of line segments include a first elliptical arc segment a1 and a second elliptical arc segment a2 arranged opposite to each other in a second direction Y, and a first circular arc segment b1 and a second circular arc segment b2 arranged opposite to each other in a third direction Z. The second direction Y intersects with the third direction Z. The first circular arc segment b1, the first elliptical arc segment a1, the second circular arc segment b2, and the second elliptical arc segment a2 are connected.

Specifically, the photovoltaic backsheet in the embodiments of the present application is used in the photovoltaic module to provide support and protection for solar cell strings within the photovoltaic module. The photovoltaic backsheet is a glass backsheet, which is made of a material including, for example, semi-tempered glass and fully tempered glass. Certainly, the photovoltaic backsheet is also made of other materials, which is not limited in the embodiments of the present application.

The photovoltaic backsheet includes the backsheet body 100. The backsheet body 100 is provided with the at least one terminal lead-out hole 110. When the photovoltaic backsheet is used in the photovoltaic module, the lead-out terminals 300 led out from the solar cell strings penetrate out of the terminal lead-out hole 110, to connect to a junction box.

It should be understood that the backsheet body 100 includes two opposite sides, namely a first side and a second side. When the photovoltaic backsheet is used in the photovoltaic module, the first side is arranged towards the solar cell strings within the photovoltaic module, while the second side is arranged away from the solar cell strings. Typically, the junction box is arranged on the second side of the backsheet body 100, corresponding to a position of the terminal lead-out hole 110, and the junction box is adhesively fixed to a portion of the backsheet body 100 around the terminal lead-out hole 110.

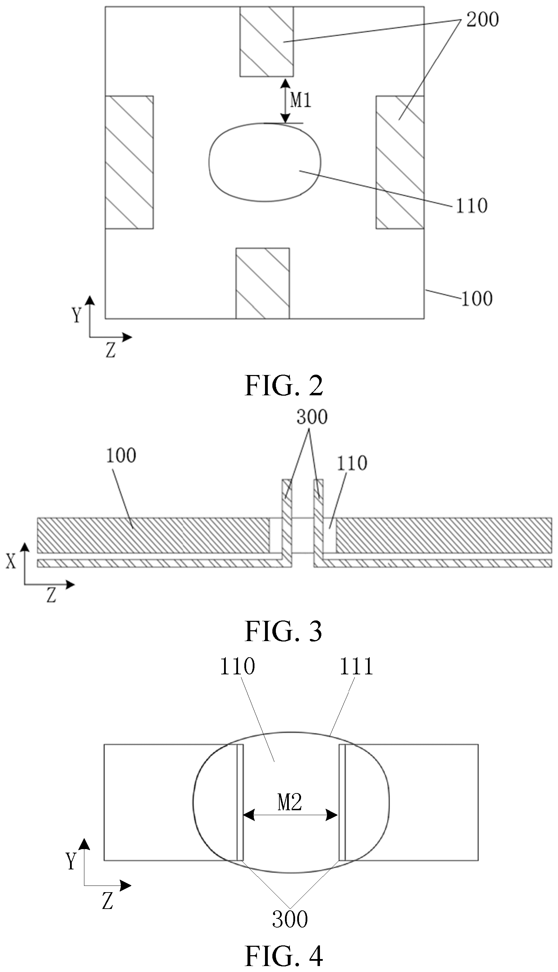

As shown in FIG. 3, the terminal lead-out hole 110 extends from the first side to the second side in the first direction X. Specifically, as shown in FIG. 1, the backsheet body 100 is a cuboid with certain length, certain width, and certain thickness, where the length of the backsheet body 100 is greater than the width of the backsheet body 100, and both the length and the width of the backsheet body 100 are greater than the thickness of backsheet body 100. The first direction X is a thickness direction along the backsheet body 100, the second direction Y is a length or long-edge direction along the backsheet body 100, and the third direction Z is a width or short-edge direction along the backsheet body 100.

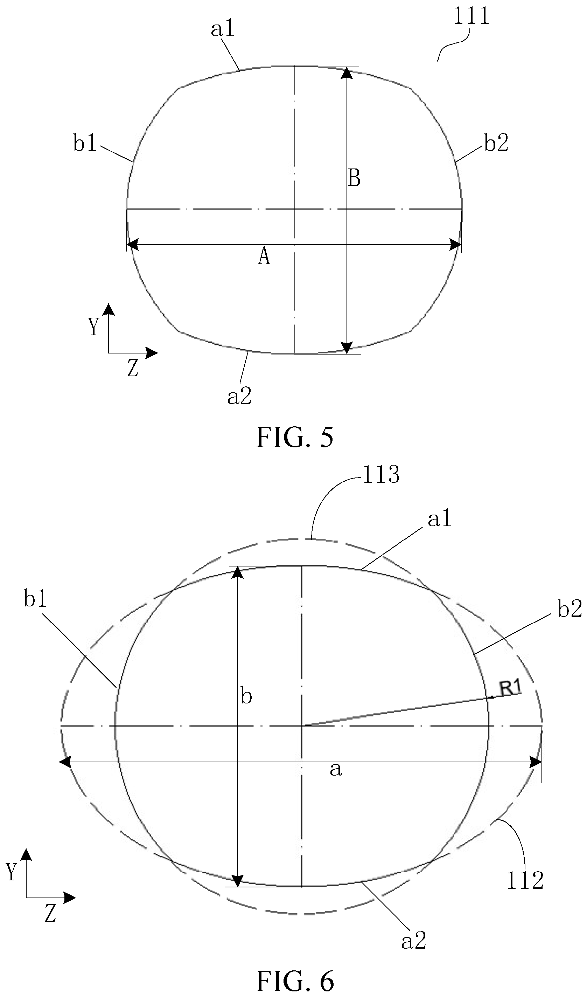

As shown in FIG. 4 and FIG. 5, the projection trajectory 111 of the terminal lead-out hole 110 in the first direction X is formed by connecting a plurality of line segments. The plurality of line segments include the first elliptical arc segment a1 and the second elliptical arc segment a2 arranged opposite to each other in the second direction Y, and the first circular arc segment b1 and the second circular arc segment b2 arranged opposite to each other in the third direction Z. The second direction Y intersects with the third direction Z. Therefore, the first circular arc segment b1, the first elliptical arc segment a1, the second circular arc segment b2, and the second elliptical arc segment a2 are sequentially connected to form the projection trajectory 111 of the terminal lead-out hole 110. It should be understood that the first direction X is perpendicular to a plane formed by the second direction Y and the third direction Z, that is, the first direction X is perpendicular to a plane formed in the length or long-edge direction of the backsheet body 100 and the corresponding width or short-edge direction of the backsheet body 100, and the second direction Y is perpendicular to the third direction Z.

The projection trajectory refers to a trajectory formed by a projection of the terminal lead-out hole 110, in the first direction X, onto a plane perpendicular to the first direction X. The first elliptical arc segment a1 and the second elliptical arc segment a2 refer to line segments on the projection trajectory 111 that are at least in the form of elliptical arc lines, while the first circular arc segment b1 and the second circular arc segment b2 refer to line segments on the projection trajectory 111 that are at least in the form of circular arc lines. In some embodiments, the projection trajectory 111 also exhibits an elliptical-like structure that closely resembles or is similar to an ellipse, or a structure that contains elliptical arc segments.

It should be understood that typically, at least two lead-out terminals 300 need to pass through a single terminal lead-out hole 110, and the two lead-out terminals 300 are at least partially parallel to each other. Certain spacing needs to be maintained between the two corresponding lead-out terminals 300 that are at least partially parallel to each other to avoid mutual contact and causing a short circuit.

Compared to conventional circular holes, by adopting a shape structure of the terminal lead-out hole 110 in the embodiments of the present application, some of structural characteristics of the elliptical hole are retained, which are used for alleviating stress concentration of the portion around the terminal lead-out hole 110 and improving an overall structural strength of the photovoltaic backsheet. Compared to the elliptical holes, a positional layout of the lead-out terminals and the elliptical hole is optimized, and meanwhile it can be ensured that a sufficient space exists within the terminal lead-out hole 110 for the passage of the lead-out terminals 300. Moreover, an effective usable area of the backsheet body 100 occupied due to the formation of the terminal lead-out hole 110 is also reduced, thereby facilitating the connection of the backsheet body 100 to other components (e.g., the junction box), reducing the amount of the adhesive film for filling, and thus lowering production and manufacturing costs.

Therefore, in the embodiments of the present application, by arranging the at least one terminal lead-out hole 110 in the photovoltaic backsheet, the lead-out terminals 300 in the photovoltaic module pass through the terminal lead-out hole 110. The lead-out terminals 300 run through the two opposite sides of the backsheet body 100 in the first direction X, and the projection trajectory 111 of the terminal lead-out hole 110 in the first direction X is composed of the plurality of line segments. The plurality of line segments include the first elliptical arc segment a1 and the second elliptical arc segment a2 that are arranged opposite to each other in the second direction Y, and the first circular arc segment b1 and the second circular arc segment b2 arranged opposite to each other in the third direction Z. By adopting the structure of the terminal lead-out hole 110 in the present application, a sufficient space is provided for the passage of the lead-out terminals 300, and meanwhile a structural layout of the terminal lead-out hole 110 in the backsheet body 100 is optimized. Moreover, by adopting the structure of the terminal lead-out hole 110 in the present application, the effective usable area of the backsheet body 100 occupied by the terminal lead-out hole 110 is reduced, thereby enhancing the usage performance of the photovoltaic backsheet.

In some embodiments, the photovoltaic backsheet in the present application is used in the photovoltaic module, and the photovoltaic module is capable of bearing mechanical loads greater than or equal to 2400 Pa. Specifically, the mechanical loads are static mechanical loads.

Compared to a photovoltaic module in the related art, the photovoltaic module formed by adopting the photovoltaic backsheet in the embodiments of the present application has a superior load-bearing capacity. During onboard testing of the photovoltaic module, such as standard 2400 Pa mechanical load tests, specifically standard 2400 Pa static mechanical load tests where the photovoltaic module is subjected to external loads, the photovoltaic backsheet of the photovoltaic module is less prone to hot spots, bursting, crushing, and the like, thereby improving the load-bearing resistance of the photovoltaic module.

In an embodiment, as shown in FIG. 5, a maximum dimension A of the projection trajectory 111 of the terminal lead-out hole 110 in the third direction Z is greater than a maximum dimension B of the projection trajectory 111 in the second direction Y.

In the embodiments of the present application, by arranging the terminal lead-out hole 110 in the backsheet body 100, the maximum dimension A of the projection trajectory 111 of the terminal lead-out hole 110 in the third direction Z is greater than the maximum dimension B of the projection trajectory 111 in the second direction Y, and some of the structural characteristics of the elliptical hole are retained, which is used for alleviating the stress concentration of the portion around the terminal lead-out hole 110 and improving the overall structural strength of the backsheet body 100.

Additionally, compared to the elliptical terminal lead-out hole 110 used in the related art, adopting the structure of the terminal lead-out hole 110 in the embodiments of the present application reduces the effective area of the photovoltaic backsheet occupied by the terminal lead-out hole 110, thereby allowing for more space on the photovoltaic backsheet for adhesive fixing with the junction box, and thus improving connection reliability between the junction box and the photovoltaic backsheet.

Further, compared to the elliptical holes in the related art, adopting the terminal lead-out hole 110 in the embodiments of the present application reduces the amount of the adhesive film required to fill the terminal lead-out hole 110 during assembly and use. Moreover, when laser drilling is employed, the machining path required to form the terminal lead-out hole 110 is also shortened, thereby reducing the production costs.

In some embodiments, the backsheet body 100 is provided with one terminal lead-out hole 110 or is provided with a plurality of terminal lead-out holes 110. When the number of the terminal lead-out holes 110 is two or above, at least one terminal lead-out hole 110 is configured as the terminal lead-out hole 110 that have the projection trajectory 111 in the above-mentioned embodiments.

The positions and number of the terminal lead-out holes 110 on the backsheet body 100 are flexibly set according to actual needs, which are not limited in the embodiments of the present application.

In an embodiment, as shown in FIG. 1 and FIG. 5, the backsheet body 100 includes two opposite short edges 101 and two opposite long edges 102. The second direction Y is set parallel to an extending direction of the long edges 102, and the third direction Z is set parallel to an extending direction of the short edges 101.

In the embodiments of the present application, by arranging the two elliptical arc segments of the projection trajectory 111 opposite to each other in the extending direction of the long edges 102 of the backsheet body 100 and the two circular arc segments of the projection trajectory 111 opposite to each other in the extending direction of the short edges 101 of the backsheet body 100, the distribution of the terminal lead-out hole 110 is made compatible with the structure of the backsheet body 100.

It should be understood that when the terminal lead-out hole 110 is a circular hole, during the application of force to the entire backsheet body 100, the portion around the terminal lead-out hole 110 is prone to cracking due to local stress concentration. Accordingly, by properly configuring the shape structure of the terminal lead-out hole 110 in the backsheet body 100, some of the structural characteristics of the elliptical holes are retained, which are used for alleviating local stress concentration of the portion around the terminal lead-out hole 110 and improving the overall structural strength of the backsheet body 100. Therefore, when the photovoltaic backsheet is used in the photovoltaic module, the load-bearing capacity of the photovoltaic module is improved.

In an embodiment, as shown in FIG. 5, the maximum dimension of the projection trajectory 111 of the terminal lead-out hole 110 in the third direction Z is A, satisfying: A < 20 mm.

In the embodiments of the present application, by setting a proper value range for the maximum dimension A of the projection trajectory 111 in the third direction Z, a sufficient space is ensured within the terminal lead-out hole 110 for the passage of the lead-out terminals 300, thereby satisfying actual usage requirements while avoiding excessive occupation of the effective usable area of the backsheet body 100 by the terminal lead-out hole 110.

It should be understood that typically, at least two lead-out terminals 300 need to pass through a single terminal lead-out hole 110, and the at least two lead-out terminals 300 are spaced apart in the third direction Z. If the maximum dimension A of the projection trajectory 111 in the third direction Z is too small, a space for passage of the lead-out terminals 300 within the terminal lead-out hole 110 is limited, affecting the passage of the lead-out terminals 300. Conversely, if the maximum dimension A of the projection trajectory 111 in the third direction Z is too large, more effective usable area of the backsheet body 100 is occupied, affecting the usage performance of the backsheet body 100.

Exemplarily, the maximum dimension A of the projection trajectory 111 in the third direction Z is set to any value or a range between any two values, such as 7 mm, 8 mm, 9 mm, 10 mm, 11 mm, 13 mm, 15 mm, 18 mm, and 19 mm.

It should be noted that a method for measuring the maximum dimension A of the projection trajectory 111 in the third direction Z includes: a straight-line distance between any two points on the projection trajectory 111 in the third direction Z is measured using a dimension measuring tool such as a caliper, and a straight line between the two points is parallel to the third direction Z. A maximum value is taken as a measured value of the maximum dimension A.

In an embodiment, as shown in FIG. 5, the maximum dimension of the projection trajectory 111 in the second direction Y is B, satisfying: 6 mm ≤ B ≤ 18 mm.

In the embodiments of the present application, by setting a proper value range for the maximum dimension B of the projection trajectory 111 in the second direction Y, a sufficient space is ensured within the terminal lead-out hole 110 for the passage of the lead-out terminals 300, thereby satisfying actual usage requirements while avoiding excessive occupation of the effective usable area of the backsheet body 100 by the terminal lead-out hole 110.

It should be understood that, as shown in FIG. 4, when the lead-out terminals 300 pass through the terminal lead-out hole 110, a width direction of the lead-out terminals 300 aligns with the second direction Y. If the maximum dimension B of the projection trajectory 111 in the second direction Y is too small, when the lead-out terminals 300 pass through the terminal lead-out hole 110, the passage of the lead-out terminals 300 is affected or the lead-out terminals 300 deform during the passage. Conversely, if the maximum dimension B of the projection trajectory 111 in the second direction Y is too large, more effective usable area of the backsheet body 100 is occupied, affecting the usage performance of the backsheet body 100.

Exemplarily, the maximum dimension B of the projection trajectory 111 in the second direction Y is set to any value or a range between any two values, such as 6 mm, 8 mm, 9 mm, 10 mm, 11 mm, 13 mm, 15 mm, 16 mm, 17 mm, and 18 mm.

It should be noted that a method for measuring the maximum dimension B of the projection trajectory 111 in the second direction Y includes: a straight-line distance between any two points on the projection trajectory 111 in the second direction Y is measured using a dimension measuring tool such as a caliper, and a straight line between the two points is parallel to the second direction Y. A maximum value is taken as a measured value of the maximum dimension B.

It should be noted that, in a case that the maximum dimension A of the projection trajectory 111 in the third direction Z is greater than the maximum dimension B of the projection trajectory 111 in the second direction Y, specific dimensions of the maximum dimension A of the projection trajectory 111 in the third direction Z and the maximum dimension B of the projection trajectory 111 in the second direction Y are also adjusted not to the above-mentioned values according to actual conditions, and are flexibly set according to actual needs, which are not limited in the embodiments of the present application.

In an embodiment, as shown in FIG. 5, the first elliptical arc segment a1 and the second elliptical arc segment a2 are symmetrically distributed about an axis in the second direction Y.

In the embodiments of the present application, by configuring the first elliptical arc segment a1 and the second elliptical arc segment a2 of the projection trajectory 111 to be symmetrically distributed about the axis in the second direction Y, namely the corresponding terminal lead-out hole 110 is symmetrically distributed in the second direction Y, a corresponding symmetry axis is located between the first elliptical arc segment a1 and the second elliptical arc segment a2. In this way, the structural distribution uniformity on two sides of the terminal lead-out hole 110 in the second direction Y is improved, some of structural characteristics of an ellipse are retained, and a proper structural layout of the terminal lead-out hole 110 in the backsheet body 100 is optimized. Therefore, when the photovoltaic backsheet is used in the photovoltaic module, the load-bearing capacity of the photovoltaic module is improved.

In some embodiments, the first elliptical arc segment a1 and the second elliptical arc segment a2 are also arranged in an asymmetric distribution. In this way, shape structures of the first elliptical arc segment a1 and the second elliptical arc segment a2 are flexibly adjusted according to actual design requirements, thereby changing the structure of the formed projection trajectory 111 to satisfy different usage needs.

In an embodiment, as shown in FIG. 5 and FIG. 6, the first circular arc segment b1 and the second circular arc segment b2 are symmetrically distributed about an axis in the third direction Z.

In the embodiments of the present application, by configuring the first circular arc segment b1 and the second circular arc segment b2 of the projection trajectory 111 to be symmetrically distributed about the axis in the third direction Z, namely the corresponding terminal lead-out hole 110 is symmetrically distributed in the third direction Z, a corresponding symmetry axis is located between the first circular arc segment b1 and the second circular arc segment b2. In this way, the structural distribution uniformity on two sides of the terminal lead-out hole 110 in the third direction Z is improved, and the proper structural layout of the terminal lead-out hole 110 in the backsheet body 100 is optimized. Therefore, when the photovoltaic backsheet is used in the photovoltaic module, a positional layout of the lead-out terminals and the terminal lead-out hole is optimized, a sufficient space is ensured within the terminal lead-out hole 110 for the passage of the lead-out terminals 300, and the amount of the adhesive film is also reduced.

In some embodiments, the first circular arc segment b1 and the second circular arc segment b2 are also arranged in an asymmetric distribution. In this way, shape structures of the first circular arc segment b1 and the second circular arc segment b2 are flexibly adjusted according to actual design requirements, thereby changing the structure of the formed projection trajectory 111 to satisfy different usage needs.

In an embodiment, as shown in FIG. 5 and FIG. 6, the first elliptical arc segment a1 and the second elliptical arc segment a2 are located on a same ellipse 112.

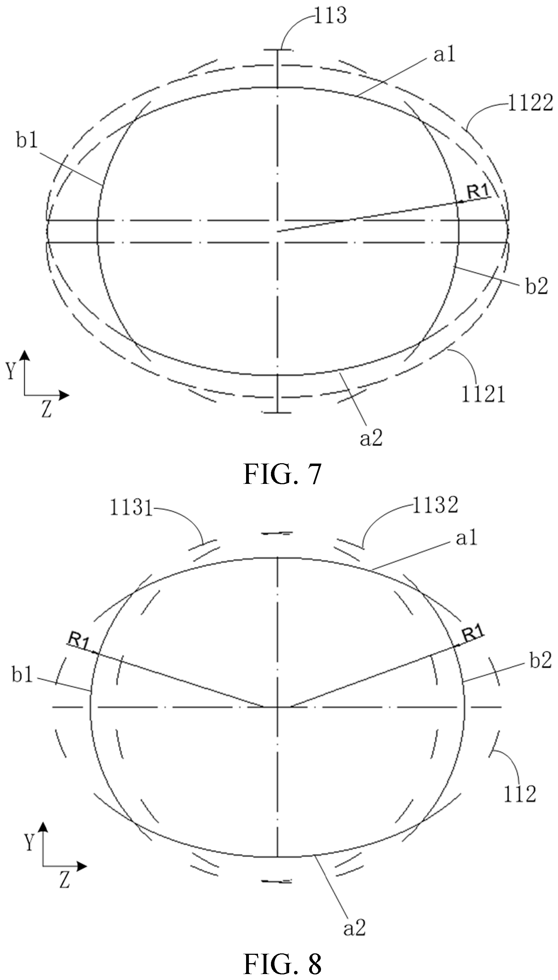

In some embodiments, the first elliptical arc segment a1 and the second elliptical arc segment a2 correspond to one ellipse 112. As shown in FIG. 6, the first elliptical arc segment a1 and the second elliptical arc segment a2 are arranged to be located on the same ellipse 112. Alternatively, as shown in FIG. 7, the first elliptical arc segment a1 and the second elliptical arc segment a2 are arranged to be located on a first ellipse 1121 and a different second ellipse 1122, and shapes of the first elliptical arc segment a1 and the second elliptical arc segment a2 are inconsistent. In some embodiments, a line connecting a center of the first ellipse 1121 where the first elliptical arc segment is located and a center of the second ellipse 1122 where the second elliptical arc segment is located is parallel to the second direction Y. More specifically, a line connecting the center of the first ellipse 1121 where the first elliptical arc segment is located, a center of a circle 113, and the center of the second ellipse 1122 where the second elliptical arc segment is located is parallel to the second direction Y. In the second direction Y, a straight-line distance between the center of the first ellipse 1121 and the center of the second ellipse 1122 is denoted as K, and a value of K is properly set, such as 0 mm ≤ K ≤ 3 mm. Those skilled in the art can flexibly set the value according to actual needs, which is not limited in the embodiments of the present application.

Specifically, in the embodiments of the present application, by arranging the first elliptical arc segment a1 and the second elliptical arc segment a2 on the same ellipse 112, two elliptical arc segments on the ellipse 112 form a portion of the projection trajectory 111, thereby facilitating the design and machining of the terminal lead-out hole 110.

In an embodiment, as shown in FIG. 5 and FIG. 6, the first circular arc segment b1 and the second circular arc segment b2 are located on the same circle 113.

In some embodiments, the first circular arc segment b1 and the second circular arc segment b2 correspond to one circle 113. As shown in FIG. 6, the first circular arc segment b1 and the second circular arc segment b2 are arranged to be located on the same circle 113. Alternatively, as shown in FIG. 8, the first circular arc segment b1 and the second circular arc segment b2 are arranged to be located on a first circle 1131 and a different second circle 1132. In some embodiments, a line connecting a center of the first circle 1131 where the first circular arc segment is located and a center of the second circle 1132 where the second circular arc segment is located is parallel to the third direction Z. More specifically, a line connecting the center of the first circle 1131 where the first circular arc segment is located, a center of the ellipse 112, and the center of the second circle 1132 where the second circular arc segment is located is parallel to the third direction Z. Those skilled in the art can flexibly set this arrangement according to actual needs, which is not limited in the embodiments of the present application.

Specifically, in the embodiments of the present application, by arranging the first circular arc segment b1 and the second circular arc segment b2 on the same circle 113, two circular arc segments on the circle 113 form a portion of the projection trajectory 111, thereby optimizing a structural design of the terminal lead-out hole 110 and facilitating actual machining of the terminal lead-out hole 110.

In some embodiments, a length of a major axis of an ellipse where the first elliptical arc segment a1 is located is A1, and a length of a minor axis of the ellipse is B1, satisfying: 1.1 ≤ A1/B1 ≤ 1.9; and/or, a length of a major axis of an ellipse where the second elliptical arc segment a2 is located is A2, and a length of a minor axis of the ellipse is B2, satisfying: 1.1 ≤ A2/B2 ≤ 1.9.

Specifically, as shown in FIG. 6, the first elliptical arc segment a1 and the second elliptical arc segment a2 are located on the same ellipse 112. The length A1 of the major axis of the ellipse where the first elliptical arc segment a1 is located and the length A2 of the major axis of the ellipse where the second elliptical arc segment a2 is located are both equal to a length a of a major axis of the ellipse 112, namely, A1 = A2 = a; and the length B1 of the minor axis of the ellipse where the first elliptical arc segment a1 is located and the length B2 of the minor axis of the ellipse where the second elliptical arc segment a2 is located are both equal to a length b of a minor axis of the ellipse 112, namely, B1 = B2 = b, satisfying: 1.1 ≤ a/b ≤ 1.9.

In the embodiments of the present application, by setting a ratio a/b of the major axis to the minor axis of the ellipse 112 where the first elliptical arc segment a1 and the second elliptical arc segment a2 are located, it is ensured that the corresponding terminal lead-out hole 110 has a sufficient space for the passage of the lead-out terminals 300 while avoiding excessive occupation of the effective usable area of the backsheet body 100 by the formation of the terminal lead-out hole 110, which affects the use of the photovoltaic backsheet.

Exemplarily, ratios A1/B1, A2/B2, and a/b are set to any value or a range between any two values, such as 1.1, 1.2, 1.3, 1.4, 1.5, 1.6, 1.7, 1.8, and 1.9.

It should be understood that the projection trajectory 111 of the terminal lead-out hole 110 is composed of the elliptical arc segments and the circular arc segments. Dimensions of the elliptical arc segments affect a shape structure of the formed projection trajectory 111. Therefore, by setting the length a of the major axis and the length b of the minor axis of the ellipse 112, structural design requirements for the terminal lead-out hole 110 are satisfied.

In an embodiment, the lengths A1 and A2 of the major axes of the ellipses satisfy: 8 mm ≤ A1 ≤ 20 mm, and 8 mm ≤ A2 ≤ 20 mm; and/or, the lengths B1 and B2 of the minor axes of the ellipses satisfy: 6 mm ≤ B1 ≤ 15 mm, and 6 mm ≤ B2 ≤ 15 mm.

Specifically, as shown in FIG. 6, the first elliptical arc segment a1 and the second elliptical arc segment a2 are located on the same ellipse 112. The length A1 of the major axis of the ellipse where the first elliptical arc segment a1 is located and the length A2 of the major axis of the ellipse where the second elliptical arc segment a2 is located are both equal to the length a of the major axis of the ellipse 112, that is, A1 = A2 = a, and correspondingly, the length a of the major axis of the ellipse 112 satisfies: 8 mm ≤ a ≤ 20 mm.

In the embodiments of the present application, by setting proper value ranges for the lengths A1, A2, and a of the major axes, the structure and dimensions of the corresponding elliptical arc segments are controlled to satisfy the structural design requirements for the terminal lead-out hole 110.

The length a of the major axis of the ellipse 112 affects the maximum dimension A of the formed projection trajectory 111 in the third direction Z. Therefore, by setting a proper value range for the length a of the major axis of the ellipse 112, a dimension range of the maximum dimension A of the projection trajectory 111 in the third direction Z is controlled.

Exemplarily, A1, A2, and a are set to any value or a range between any two values, such as 8 mm, 10 mm, 13 mm, 16 mm, 18 mm, and 20 mm.

Meanwhile, as shown in FIG. 6, the first elliptical arc segment a1 and the second elliptical arc segment a2 are located on the same ellipse 112. The length B1 of the minor axis of the ellipse where the first elliptical arc segment a1 is located and the length B2 of the minor axis of the ellipse where the second elliptical arc segment a2 is located are both equal to the length b of the minor axis of the ellipse 112, that is, B1 = B2 = b, and correspondingly, the length b of the minor axis of the ellipse 112 satisfies: 6 mm ≤ b ≤ 15 mm.

In the embodiments of the present application, by setting proper value ranges for the lengths B1, B2, and b of the minor axes, the structure and dimensions of the corresponding elliptical arc segments are controlled to satisfy the structural design requirements for the terminal lead-out hole 110.

The length b of the minor axis of the ellipse 112 affects the maximum dimension B of the projection trajectory 111 in the second direction Y. Therefore, by setting a proper value range for the length b of the minor axis of the ellipse 112, a dimension range of the maximum dimension B of the projection trajectory 111 in the second direction Y is controlled.

Exemplarily, the lengths B1, B2, and b are set to any value or a range between any two values, such as 6 mm, 8 mm, 10 mm, 12 mm, and 15 mm.

In some embodiments, the length a of the major axis and the length b of the minor axis of the ellipse 112 are set to combined dimensions such as 18 mm and 12 mm, 16 mm and 10 mm, or 16 mm and 12 mm. Certainly, the specific dimensions of the length a of the major axis and the length b of the minor axis of the ellipse 112 are flexibly set according to actual needs, which are not limited in the embodiments of the present application.

In an embodiment, a radius of a circle where the first circular arc segment is located is R11, satisfying: 3 mm ≤ R11 ≤ 10 mm; or, a radius of a circle where the second circular arc segment is located is R12, satisfying: 3 mm ≤ R12 ≤ 10 mm.

Specifically, as shown in FIG. 6, the first circular arc segment b1 and the second circular arc segment b2 are located on the same circle 113. The radius R11 of the circle where the first circular arc segment is located and the radius R12 of the circle where the second circular arc segment is located are both equal to a radius R1 of the circle 113, that is, R11 = R12 = R1, which correspondingly satisfies: 3 mm ≤ R1 ≤ 10 mm. By setting a proper value range for the radius R1 of the circle 113 where the first circular arc segment b1 or the second circular arc segment b2 is located, it is ensured that the corresponding terminal lead-out hole 110 has a sufficient space for the passage of the lead-out terminals 300 while avoiding excessive occupation of the effective usable area of the backsheet body 100 by the terminal lead-out hole 110.

It should be understood that the first circular arc segment b1 and/or the second circular arc segment b2 are/is arranged opposite to each other in the third direction Z. A distance between the first circular arc segment b1 and the second circular arc segment b2 affects the maximum dimension A of the formed projection trajectory 111 in the third direction Z. Therefore, by setting the radius R1 of the circle 113, the maximum dimension A of the projection trajectory 111 of the terminal lead-out hole in the third direction Z is controlled within a proper range.

Exemplarily, the radius R11 of the circle where the first circular arc segment b1 is located and the radius R12 of the circle where the second circular arc segment b2 is located are set to any value or a range between any two values, such as 3 mm, 5 mm, 7 mm, 7.5 mm, 8 mm, and 10 mm.

It should be noted that the radii R11 and R12 of the first circular arc segment b1 and the second circular arc segment b2 are set to be the same or different, which is not limited in the embodiments of the present application.

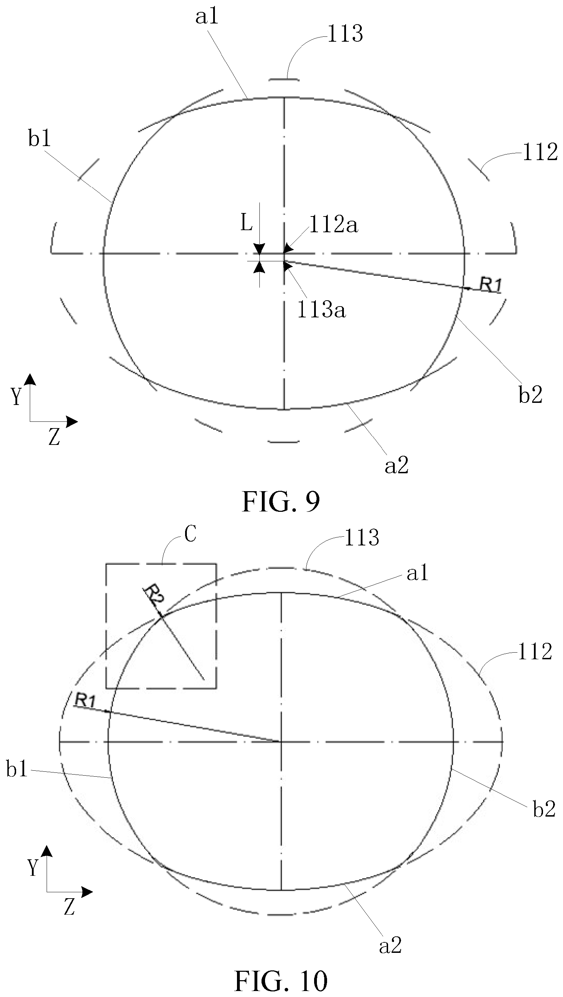

In an embodiment, as shown in FIG. 9, the first elliptical arc segment a1 and the second elliptical arc segment a2 are located on the same ellipse 112, and the first circular arc segment b1 and the second circular arc segment b2 are located on the same circle 113. A distance between a center 112a of the ellipse 112 and a center 113a of the circle 113 is L, satisfying: 0 mm ≤ L ≤ 3 mm.

In the embodiments of the present application, by arranging the first elliptical arc segment a1 and the second elliptical arc segment a2 on the same ellipse 112 and the first circular arc segment b1 and the second circular arc segment b2 on the same circle 113, the projection trajectory 111 of the terminal lead-out hole 110 is formed by an overlapping portion of one ellipse 112 and one circle 113. Then, by setting a proper value range for the distance L between the center 112a of the ellipse 112 and the center 113a of the circle 113, the shape structure of the formed projection trajectory 111 is controlled to satisfy the structural design requirements for the terminal lead-out hole 110.

Exemplarily, the distance L between the center 112a of the ellipse 112 where the two elliptical arc segments are located and the center 113a of the circle 113 where the two circular arc segments are located is set to any value or a range between any two values, such as 0 mm, 1 mm, 1.5 mm, 2 mm, 2.5 mm, and 3 mm.

In an embodiment, as shown in FIG. 6, the center of the ellipse 112 coincides with the center of the circle 113. By setting the center of the ellipse 112 to coincide with the center of the circle 113, the formed projection trajectory 111 of the terminal lead-out hole 110 exhibits a regular symmetrical structure, optimizing the proper structural layout of the terminal lead-out hole 110 in the backsheet body 100.

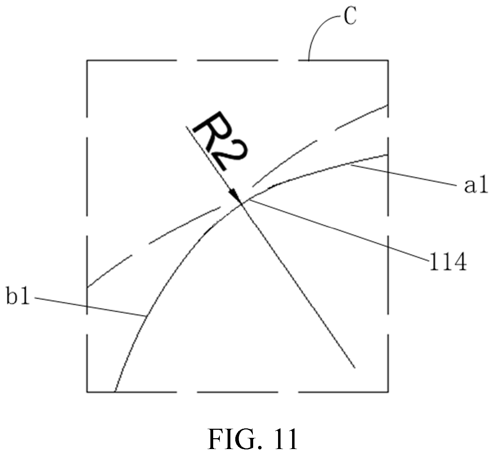

In an embodiment, as shown in FIG. 10 and FIG. 11, the plurality of line segments further include at least one arc-shaped transition segment 114. The arc-shaped transition segment 114 is arranged between adjacent elliptical arc segment and circular arc segment. One end of the arc-shaped transition segment 114 is connected to one of the first elliptical arc segment a1 and the second elliptical arc segment a2, and the other end of the arc-shaped transition segment 114 is connected to one of the first circular arc segment b1 and the second circular arc segment b2.

In the embodiments of the present application, by arranging the arc-shaped transition segment 114 between the adjacent elliptical arc segment and circular arc segment, a smooth transition between the elliptical arc segments and the circular arc segments is achieved, thereby reducing stress concentration at connection and transition positions between the elliptical arc segments and the circular arc segments.

It should be understood that a connection corner exists at the connection position between the elliptical arc segment and the circular arc segment. When subjected to force, local stress concentration occurs at the connection corner, which easily leads to cracking at the position. Therefore, connecting the elliptical arc segment and the circular arc segment through the arc-shaped transition segment 114 enables the smooth transition between the elliptical arc segment and the circular arc segment, helping to reduce stress concentration at the connection and transition position between the elliptical arc segment and the circular arc segment.

An arc forming the arc-shaped transition segment 114 includes, but is not limited to, a circular arc or an elliptical arc. A specific structure of the arc forming the arc-shaped transition segment 114 is flexibly set, which is not limited in the embodiments of the present application.

It should be noted that four connection positions exist between the two elliptical arc segments and the two circular arc segments. At least one of the four connection positions is designed as the arc-shaped transition segment 114 to form an arc-shaped transition.

In an embodiment, as shown in FIG. 10 and FIG. 11, the arc-shaped transition segment 114 is of a circular arc structure, and a radius of the circular arc structure is R2, satisfying: 0 mm < R2 ≤ 5 mm. In an embodiment, 3 mm ≤ R2 ≤ 5 mm.

In the embodiments of the present application, the arc-shaped transition segment 114 is set to the circular arc structure, so as to facilitate actual machining and manufacturing. In addition, by setting a proper value range for the radius R2 of the circular arc structure, a transition portion between the elliptical arc segment and the circular arc segment is made smoother, thereby effectively reducing stress concentration at the connection and transition position between the elliptical arc segment and the circular arc segment.

Exemplarily, the radius R2 of the arc-shaped transition segment 114 of the circular arc structure is set to any value or a range between any two values, such as 0.5 mm, 1 mm, 1.5 mm, 2 mm, 2.5 mm, 3 mm, 3.5 mm, 4 mm, 4.5 mm, and 5 mm.

In an embodiment, as shown in FIG. 1 and FIG. 2, at least one side surface of the backsheet body 100 is provided with a glaze layer 200, and a first gap exists between the glaze layer 200 and the terminal lead-out hole 110.

In the embodiments of the present application, the first gap exists between the glaze layer 200 and the terminal lead-out hole 110, thereby separating the glaze layer 200 from the terminal lead-out hole 110, and thus reducing the impact of the arrangement of the glaze layer 200 on the structural strength of a region around the terminal lead-out hole 110.

It should be understood that, when the photovoltaic backsheet is used in the photovoltaic module, to enhance the usage performance of the photovoltaic module, the glaze layer 200 is typically coated on at least one side surface of the backsheet body 100, thereby using the glaze layer 200 for reflecting light, and thus improving the photoelectric conversion efficiency of the photovoltaic module. However, during the formation of the glaze layer 200 on a surface of the backsheet body 100, technological operations such as cladding and sintering are required to be performed on the backsheet body 100, which affects the structural strength of a corresponding portion of the photovoltaic backsheet. As a result, the strength of the portion of the backsheet body 100 provided with the glaze layer 200 is lower than that of a portion without the glaze layer 200.

Therefore, in the embodiments of the present application, the first gap is formed between the glaze layer 200 on the backsheet body 100 and the terminal lead-out hole 110, so that the terminal lead-out hole 110 is staggered from the glaze layer 200, thereby avoiding the impact of the arrangement of the glaze layer 200 on the strength of the portion around the terminal lead-out hole 110, and thus reducing the risk of cracking around the terminal lead-out hole 110 when the photovoltaic backsheet is subjected to force.

In an embodiment, as shown in FIG. 2, a dimension of the first gap is M1, satisfying: 3.5 mm ≤ M1 ≤ 9.5 mm.

In the embodiments of the present application, a plurality of glaze layers 200 are arranged, and a first gap M1 is formed between the glaze layer 200 and an outermost end of the corresponding terminal lead-out hole 110. By setting a proper value range for the dimension M1 of the first gap, it is ensured that when the photovoltaic backsheet is used in the photovoltaic module, the power generation efficiency of the photovoltaic module is improved while the strength of the photovoltaic backsheet around the terminal lead-out hole 110 is maintained.

Exemplarily, the dimension M1 of the first gap is set to any value or a range between any two values, such as 3.5 mm, 4 mm, 4.5 mm, 5 mm, 5.5 mm, 6 mm, 6.5 mm, 8.5 mm, and 9.5 mm.

In an embodiment, as shown in FIG. 1, the terminal lead-out hole 110 is offset from a center of the backsheet body 100.

It should be understood that the stress at the center position of the backsheet body 100 is typically concentrated. Therefore, by offsetting the terminal lead-out hole 110 from the center of the backsheet body 100, the proper layout of the terminal lead-out hole 110 is optimized, and the impact of the formation of the terminal lead-out hole 110 on the structural strength of the backsheet body 100 is reduced.

In some embodiments, by forming the terminal lead-out hole 110 in the above-mentioned embodiments in the backsheet body 100 of the photovoltaic backsheet and forming the elliptical hole in the related art respectively, a four-point bending strength test is performed on the photovoltaic backsheet.

Specifically, the photovoltaic backsheet of the same dimension is selected for Embodiment 1 and Comparative Example 1, with a length of 2272 mm, a width of 1128 mm, and a thickness of 2 mm. The photovoltaic backsheet in Embodiment 1 adopts the terminal lead-out hole 110 in the embodiments of the present application. The first elliptical arc segment a1 and the second elliptical arc segment a2 of the projection trajectory 111 of the terminal lead-out hole 110 are located on the same ellipse 112, and the first circular arc segment b1 and the second circular arc segment b2 are located on the same circle 113. The photovoltaic backsheet in Comparative Example 1 adopts the elliptical hole in the related art, and an elliptical structure of the elliptical hole is identical to the structure of the ellipse where the first elliptical arc segment a1 and the second elliptical arc segment a2 in Embodiment 1 are located.

Subsequently, a four-point bending strength performance test is performed on the two types of photovoltaic backsheets using a four-point bending test device. Under the same testing environment, a spacing between two force bearing points on an upper surface of the photovoltaic backsheet is 200 mm, while a spacing between two force bearing points on a lower surface of the photovoltaic backsheet is 700 mm. Results of test experiments are shown in Table 1 below:

**Table 1**

| Ratio of Major Axis to Minor Axis of Ellipse (a/b) | Length of Major Axis a of Ellipse (mm) | Length of Minor Axis b of Ellipse (mm) | Embodiment 1 | Comparative Example 1 |
|---|---|---|---|---|
| | | | Four-point bending strength (MPa) | Four-point bending strength (MPa) |
| 1.1 | 11 | 10 | 133 | 119 |
| 1.2 | 12 | 10 | 128 | 111 |
| 1.5 | 15 | 10 | 124 | 106 |
| 1.6 | 16 | 10 | 120 | 100 |
| 1.9 | 19 | 10 | 110 | 98 |

From the test results in Table 1 above, it is observed that, compared to the arrangement of the elliptical hole in the photovoltaic backsheet according to the related art, employing the terminal lead-out hole 110 in the embodiments of the present application enhances the four-point bending strength of the photovoltaic backsheet and also improves the overall structural strength of the photovoltaic backsheet.

In some embodiments, alternatively, the first circular arc segment b1 is a first straight line segment, a first polyline segment, or another line segment; and/or, alternatively, the second circular arc segment b2 is a second straight line segment, a second polyline segment, or another line segment.

Specifically, the first circular arc segment b1 is a first straight line segment, a first polyline segment, or another line segment, and the second circular arc segment b2 is a second straight line segment, a second polyline segment, or another line segment. That is, the projection trajectory 111 of the terminal lead-out hole 110 in the first direction X is formed by connecting a plurality of line segments, and the plurality of line segments include the first elliptical arc segment a1, the first straight line segment or the first polyline segment or the another line segment, the second elliptical arc segment a2, and the second straight line segment or the second polyline segment or the another line segment.

In some embodiments, the plurality of line segments include the first elliptical arc segment a1, the first straight line segment, the second elliptical arc segment a2, and the second straight line segment; and the first elliptical arc segment a1, the first straight line segment, the second elliptical arc segment a2, and the second straight line segment are connected sequentially. In this way, the photovoltaic backsheet has more space for adhesive fixing with the junction box, thereby improving the connection reliability between the junction box and the photovoltaic backsheet, and also reducing the amount of the adhesive film required to fill the terminal lead-out hole 110 during assembly and use. Moreover, when laser drilling is employed, the machining path required to form the terminal lead-out hole 110 is also shortened, thereby reducing the production costs. It should be noted that the another type of segment is formed by a combination of straight lines and curves.

In some other embodiments, the first direction X is still the thickness direction along the backsheet body 100, the second direction Y is the width or short-edge direction along the backsheet body 100, and the third direction Z is the length or long-edge direction along the backsheet body 100. The backsheet body 100 includes two opposite short edges 101 and two opposite long edges 102. The second direction Y is set parallel to the extending direction of the short edges, and the third direction Z is set parallel to the extending direction of the long edges. The maximum dimension of the projection trajectory 111 of the terminal lead-out hole 110 in the third direction Z is greater than the maximum dimension of the projection trajectory 111 in the second direction Y.

It should be understood that the above is a design for adjusting the position of the terminal lead-out hole 110, and correspondingly involves rotating a center of the terminal lead-out hole 110 shown in FIG. 2 upwards or downwards by 90 degrees or another angle. This design is clearly feasible and can still incorporate all the technical content of any one of the above-mentioned embodiments of the photovoltaic backsheet. For details, please refer to the preceding content, and details are not described herein again. The effective area of the photovoltaic backsheet occupied by forming the terminal lead-out hole 110 is also reduced. Therefore, the photovoltaic backsheet has more space for adhesive fixing with the junction box, thereby improving the connection reliability between the junction box and the photovoltaic backsheet, and also reducing the amount of the adhesive film required to fill the terminal lead-out hole 110 during assembly and use. Moreover, when laser drilling is employed, the machining path required to form the terminal lead-out hole 110 is also shortened, thereby reducing the production costs.

It should be noted that the maximum dimension A of the projection trajectory 111 in the third direction Z, the maximum dimension B of the projection trajectory 111 in the second direction Y, the length dimension A1 of the major axis and the length dimension B1 of the minor axis of the ellipse where the first elliptical arc segment is located, the length dimension A2 of the major axis and the length dimension B2 of the minor axis of the ellipse where the second elliptical arc segment is located, the radius dimension R11 of the circle where the first circular arc segment is located, the radius dimension R12 of the circle where the second circular arc segment is located, the distances K and L, the dimension M1 of the first gap, the radius R2 of the circular arc structure, and a subsequent spacing M2 are uniformly and flexibly matched and set according to actual needs, which are not limited in the embodiments of the present application.

According to another aspect, the present application further provides a photovoltaic module, which includes solar cell strings, lead-out terminals 300, and the photovoltaic backsheet according to any one of the above-mentioned embodiments. One end of the lead-out terminal 300 is connected to the solar cell strings, and the other end of the lead-out terminal 300 passes through a terminal lead-out hole 110.

In the embodiments of the present application, by arranging at least one terminal lead-out hole 110 in the photovoltaic backsheet, the lead-out terminals 300 in the photovoltaic module pass through the terminal lead-out hole 110. The lead-out terminals 300 run through two opposite sides of a backsheet body 100 in a first direction X, and a projection trajectory 111 of the terminal lead-out hole 110 in the first direction X is formed by connecting a plurality of line segments. The plurality of line segments include a first elliptical arc segment a1 and a second elliptical arc segment a2 arranged opposite to each other in a second direction Y, and a first circular arc segment b1 and a second circular arc segment b2 arranged opposite to each other in a third direction Z. By adopting the structure of the terminal lead-out hole 110 in the present application, a sufficient space is provided for the passage of the lead-out terminals 300, and meanwhile a structural layout of the terminal lead-out hole 110 in the backsheet body 100 is optimized. Moreover, an effective usable area of the backsheet body 100 occupied by the terminal lead-out hole 110 is reduced, thereby allowing for more space on the photovoltaic backsheet for adhesive fixing with a junction box, and thus improving connection reliability between the junction box and the photovoltaic backsheet, and enhancing usage performance of the photovoltaic backsheet.

It should be noted that the photovoltaic module in the embodiments of the present application includes the photovoltaic backsheet described in any one of the above-mentioned embodiments. For a specific structure of the photovoltaic backsheet, referring to the preceding content, and details are not repeated in this embodiment of the present application.

In an embodiment, as shown in FIG. 3 and FIG. 4, two lead-out terminals 300 pass through the same terminal lead-out hole 110. The two lead-out terminals 300 are at least partially parallel to each other, and the two lead-out terminals 300 are spaced apart in the third direction Z.

In the embodiments of the present application, two lead-out terminals 300 pass through the same terminal lead-out hole 110. The two lead-out terminals 300 are at least partially parallel to each other, and the two lead-out terminals 300 are arranged to be spaced apart in the third direction Z, thereby satisfying passage requirements for the lead-out terminals 300 but also solving a problem about a short circuit caused by mutual contact between the two lead-out terminals 300.

In an embodiment, as shown in FIG. 4, in the third direction Z, a spacing between the two lead-out terminals 300 is M2, satisfying: 3 mm ≤ M2 ≤ 15 mm.

It should be understood that in the embodiments of the present application, an inner spacing between the two lead-out terminals 300 that are at least partially parallel is defined as the spacing M2. By setting a proper value range for the spacing M2 between the two lead-out terminals 300, the short circuit caused by the lead-out terminals 300 being close to each other is avoided, meanwhile, excessive space occupation by the terminal lead-out hole caused by a too large spacing between the two lead-out terminals 300 is also avoided, and certainly, actual mounting requirements for the junction box are also satisfied.

Exemplarily, the spacing M2 between the two lead-out terminals 300 is set to any value or a range between any two values, such as 3 mm, 4 mm, 6 mm, 7 mm, 8 mm, 9 mm, 10 mm, 12 mm, and 15 mm.

In an embodiment, as shown in FIG. 4, a sum of the spacing M2 and thicknesses of the two lead-out terminals 300 in the third direction Z is less than a maximum dimension A of the projection trajectory 111 in the third direction Z.

In the embodiments of the present application, by setting the sum of the spacing M2 and the thicknesses of the two lead-out terminals 300 in the third direction Z to be less than the maximum dimension A of the projection trajectory 111 in the third direction Z, the two lead-out terminals 300 can smoothly pass through the terminal lead-out hole 110, and moreover, the two lead-out terminals 300 are not in contact, thereby preventing the short circuit between the two lead-out terminals 300.

In an embodiment, as shown in FIG. 4, a width of the lead-out terminal 300 in the second direction Y is less than a maximum dimension B of the projection trajectory 111 in the second direction Y.

In the embodiment of the present application, by setting the width of the lead-out terminal 300 in the second direction Y to be smaller than the maximum dimension B of the projection trajectory 111 in the second direction Y, the lead-out terminal 300 can smoothly pass through the terminal lead-out hole 110, thereby preventing the terminal lead-out hole 110 from causing extrusion and deformation to the lead-out terminal 300, which affects usage performance of the lead-out terminal 300.

In the descriptions of this specification, descriptions referring to terms "an embodiment", "some embodiments", "an exemplary embodiment", "an example", "a specific example", or "some examples" mean that specific characteristics, structures, materials, or features described with reference to the embodiment or example are included in at least one embodiment or example of the present application. In this specification, exemplary descriptions of the above-mentioned terms do not necessarily refer to the same embodiment or example. In addition, the described specific characteristics, structures, materials, or features may be combined in a proper manner in any one or more of the embodiments or examples.

Although the embodiments of the present application have been shown and described, those of ordinary skill in the art should understand that various changes, modifications, replacements and variations can be made to the embodiments without departing from the principles and spirit of the present application, and the scope of the present application is as defined by the appended claims and equivalents thereof.

## Claims

1. A photovoltaic backsheet, comprising a backsheet body;
the backsheet body being provided with at least one terminal lead-out hole, the terminal lead-out hole being adapted for passage of lead-out terminals of the photovoltaic module; the terminal lead-out hole running through two opposite sides of the backsheet body in a first direction, and a projection trajectory of the terminal lead-out hole in the first direction being composed of a plurality of line segments;
the plurality of line segments comprising a first elliptical arc segment and a second elliptical arc segment arranged opposite to each other in a second direction, and
a first circular arc segment and a second circular arc segment arranged opposite to each other in a third direction, the second direction intersecting with the third direction;
or, a first straight line segment or a first polyline segment or another line segment and a second straight line segment or a second polyline segment or another line segment arranged opposite to each other in the third direction, wherein the another line segment comprises a line segment formed by combining a straight line and a curve; the second direction intersecting with the third direction.

2. The photovoltaic backsheet according to claim 1, wherein a maximum dimension of the projection trajectory in the third direction is greater than a maximum dimension of the projection trajectory in the second direction; and/or, the first direction is perpendicular to the second direction and the third direction, and the second direction is perpendicular to the third direction.

3. The photovoltaic backsheet according to claim 1, wherein the backsheet body comprises two opposite short edges and two opposite long edges; and
the second direction is set parallel to an extending direction of the long edges, and the third direction is set parallel to an extending direction of the short edges; or, the second direction is set parallel to the extending direction of the short edges, and the third direction is set parallel to the extending direction of the long edges.

4. The photovoltaic backsheet according to claim 1, wherein a maximum dimension of the projection trajectory in the third direction is A, satisfying: A < 20 mm; and/or, a maximum dimension of the projection trajectory in the second direction is B, satisfying: 6 mm ≤ B ≤ 18 mm.

5. The photovoltaic backsheet according to claim 1, wherein the first elliptical arc segment and the second elliptical arc segment are symmetrically distributed about an axis in the second direction, or, the first elliptical arc segment and the second elliptical arc segment are asymmetrically distributed in the second direction;
and/or, the first circular arc segment and the second circular arc segment are symmetrically distributed about an axis in the third direction, or, the first circular arc segment and the second circular arc segment are asymmetrically distributed in the third direction.

6. The photovoltaic backsheet according to any one of claims 1 to 5, wherein the first elliptical arc segment and the second elliptical arc segment are located on a same ellipse; or, the first circular arc segment and the second circular arc segment are located on a same circle; or, a line connecting a center of an ellipse where the first elliptical arc segment is located and a center of an ellipse where the second elliptical arc segment is located is parallel to the second direction; or, a line connecting a center of a circle where the first circular arc segment is located and a center of a circle where the second circular arc segment is located is parallel to the third direction.

7. The photovoltaic backsheet according to claim 1, wherein a length of a major axis of an ellipse where the first elliptical arc segment is located is A1, and a length of a minor axis of the ellipse is B1, satisfying: 1.1 ≤ A1/B1 ≤ 1.9; and/or, a length of a major axis of an ellipse where the second elliptical arc segment is located is A2, and a length of a minor axis of the ellipse is B2, satisfying: 1.1 ≤ A2/B2 ≤ 1.9.

8. The photovoltaic backsheet according to claim 7, wherein the lengths A1 and A2 of the major axes of the ellipses satisfy: 8 mm ≤ A1 ≤ 20 mm, and 8 mm ≤ A2 ≤ 20 mm; and/or, the lengths B1 and B2 of the minor axes of the ellipses satisfy: 6 mm ≤ B1 ≤ 15 mm, and 6 mm ≤ B2 ≤ 15 mm.

9. The photovoltaic backsheet according to claim 7, wherein the lengths A1 and A2 of the major axes of the ellipses are both 18 mm or 16 mm, and the lengths B1 and B2 of the minor axes of the ellipses are both 10 mm or 12 mm.

10. The photovoltaic backsheet according to claim 1, wherein a radius of a circle where the first circular arc segment is located is R11, satisfying: 3 mm ≤ R11 ≤ 10 mm; or, a radius of a circle where the second circular arc segment is located is R12, satisfying: 3 mm ≤ R12 ≤ 10 mm.

11. The photovoltaic backsheet according to claim 1, wherein the first elliptical arc segment and the second elliptical arc segment are located on a same ellipse, the first circular arc segment and the second circular arc segment are located on a same circle, and a distance between a center of the ellipse and a center of the circle is L, satisfying: 0 mm ≤ L ≤ 3 mm.

12. The photovoltaic backsheet according to claim 11, wherein the center of the ellipse coincides with the center of the circle; and/or, a radius R11 of the circle where the first circular arc segment is located is 3 mm, 4 mm, 5 mm, 6 mm, 7 mm, 8 mm, 9 mm; and/or, a radius R12 of the circle where the second circular arc segment is located is 3 mm, 4 mm, 5 mm, 6 mm, 7 mm, 8 mm, 9 mm.

13. The photovoltaic backsheet according to any one of claims 1 to 5, wherein when the first circular arc segment and the second circular arc segment are arranged opposite to each other in the third direction, the plurality of line segments further comprise at least one arc-shaped transition segment, the arc-shaped transition segment being arranged between the adjacent elliptical arc segment and circular arc segment, one end of the arc-shaped transition segment being connected to one of the first elliptical arc segment and the second elliptical arc segment, and the other end of the arc-shaped transition segment being connected to one of the first circular arc segment and the second circular arc segment.

14. The photovoltaic backsheet according to claim 13, wherein the arc-shaped transition segment is of a circular arc structure, and a radius of the circular arc structure is R2, satisfying: 0 mm < R2 ≤ 5 mm.

15. The photovoltaic backsheet according to claim 14, wherein the radius R2 of the circular arc structure of the arc-shaped transition segment is 1 mm, 2 mm, 3 mm, 4 mm, 5 mm.

16. The photovoltaic backsheet according to claim 1, wherein at least one side surface of the backsheet body is provided with a glaze layer, and a first gap exists between the glaze layer and the terminal lead-out hole.

17. The photovoltaic backsheet according to claim 16, wherein a dimension of the first gap is M1, satisfying: 3.5 mm ≤ M1 ≤ 9.5 mm.

18. The photovoltaic backsheet according to claim 1, wherein the terminal lead-out hole is offset from a center of the backsheet body; or, the backsheet is a glass backsheet;
or, the first circular arc segment and the second circular arc segment are located on a same circle, and a line connecting a center of an ellipse where the first elliptical arc segment is located, a center of the circle, and a center of an ellipse where the second elliptical arc segment is located is parallel to the second direction;
or, the first elliptical arc segment and the second elliptical arc segment are located on a same ellipse, and a line connecting a center of a circle where the first circular arc segment is located, a center of the ellipse, and a center of a circle where the second circular arc segment is located is parallel to the third direction;
or, the first circular arc segment or the first straight line segment or the first polyline segment or the another line segment, the first elliptical arc segment, the second circular arc segment or the second straight line segment or the second polyline segment or the another line segment, and the second elliptical arc segment are connected.

19. The photovoltaic backsheet according to claim 1, wherein the photovoltaic backsheet is used in a photovoltaic module, and the photovoltaic module is capable of bearing mechanical loads greater than or equal to 2400 Pa.

20. The photovoltaic backsheet according to claim 19, wherein the mechanical loads are static mechanical loads.

21. A photovoltaic module, comprising: solar cell strings, lead-out terminals, and the photovoltaic backsheet according to any one of claims 1 to 20; one end of the lead-out terminal being connected to the solar cell strings, and the other end of the lead-out terminal passing through the terminal lead-out hole.

22. The photovoltaic module according to claim 21, wherein two lead-out terminals pass through the same terminal lead-out hole, the two lead-out terminals being at least partially parallel to each other, and the two lead-out terminals being arranged to be spaced apart in the third direction.

23. The photovoltaic module according to claim 22, wherein in the third direction, a spacing between the two lead-out terminals is M2, satisfying: 3 mm ≤ M2 ≤ 15 mm.

24. The photovoltaic module according to claim 23, wherein a sum of the spacing and thicknesses of the two lead-out terminals in the third direction is less than a maximum dimension of the projection trajectory in the third direction.

25. The photovoltaic module according to any one of claims 21 to 24, wherein a width of the lead-out terminal in the second direction is less than a maximum dimension of the projection trajectory in the second direction.
